(19) 

Europäisches Patentamt
European Patent Office
Office européen des brevets

(11) **EP 4 458 174 A1**

(12) **EUROPEAN PATENT APPLICATION**
published in accordance with Art. 153(4) EPC

(43) Date of publication:
**06.11.2024 Bulletin 2024/45**

(21) Application number: **22915558.5**

(22) Date of filing: **11.11.2022**

(51) International Patent Classification (IPC):
**A24F 40/20** (2020.01)    **A24F 40/40** (2020.01)
**A24F 40/50** (2020.01)    **A24F 40/53** (2020.01)

(52) Cooperative Patent Classification (CPC):
**A24F 40/20; A24F 40/40; A24F 40/50; A24F 40/53**

(86) International application number:
**PCT/JP2022/042134**

(87) International publication number:
**WO 2023/127326 (06.07.2023 Gazette 2023/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.12.2021 JP 2021214319**

(71) Applicant: **Japan Tobacco Inc.
Tokyo 105-6927 (JP)**

(72) Inventors:
• **SAKAI, Ryuji
Tokyo 130-8603 (JP)**
• **INOUE, Jumpei
Tokyo 130-8603 (JP)**

(74) Representative: **Hoffmann Eitle
Patent- und Rechtsanwälte PartmbB
Arabellastraße 30
81925 München (DE)**

(54) **NON-COMBUSTION FLAVOR INHALER**

(57) A non-combustion flavor inhaler (30) comprises: an accommodation part (310) that accommodates a flavor stick (100) such that the flavor stick can be inserted into and ejected from the accommodation part, the flavor stick having a first rod part including a flavor source and a second rod part other than the first rod part; a first sensor (33) that performs detection at least at the position at which the first rod part is located when the flavor stick is accommodated in the accommodation part in a prescribed state where the first rod part of the flavor stick is located on the front end side and the second rod part thereof is located on the rear end side of the first rod part; a second sensor (34) that performs detection at least at a position at which the second rod part is located when the flavor stick is accommodated in the accommodation part in the prescribed state; and a control part (37) that determines whether the flavor stick is inserted in the prescribed state on the basis of at least one of a value detected by the first sensor and a value detected by the second sensor. Provided thereby is a device accurately detecting insertion of the flavor stick in a state different from the prescribed state.

FIG. 1

## Description

Technical Field

The present disclosure relates to a non-combustion-type flavor inhaler.

Background Art

A non-combustion-type flavor inhaling system is suggested as an alternative to an existing combustion-type tobacco that is smoked by burning tobacco leaves. For example, a non-combustion-heating-type tobacco product is known. The non-combustion-heating-type tobacco product includes an electric heating device and a tobacco stick. The electric heating device includes a heater assembly, a battery unit that serves as an electric power supply of the heater assembly, a controller that controls a heating element of the heater assembly, and the like. The tobacco stick is used together with the electric heating device.

It is under review that the non-combustion-type flavor inhaler has various functions to improve the convenience of users. For example, there is known a mechanism that, in an inhaler that heats a tobacco stick inserted in a non-combustion-type flavor inhaler by a user, detects insertion of the tobacco stick based on a change in capacitance (PTL 1). There is also known a mechanism that provides a marker on a stick side and detects insertion of the tobacco stick or the type of the tobacco stick by measuring a capacitance associated with the marker (PTL 2).

Citation List

Patent Literature

PTL 1: Japanese Unexamined Patent Application Publication (Translation of PCT Application) No. 2017-510270
PTL 2: International Publication No. 2019/185748
PTL 3: Japanese Unexamined Patent Application Publication (Translation of PCT Application) No. 2021-523683

Summary of Invention

Technical Problem

To detect information on a flavor stick (for example, a tobacco stick) and control functions including heating and the like in a non-combustion-type flavor inhaler, making it possible to accurately detect information on the flavor stick is a prerequisite. However, a flavor stick is made up of a plurality of segments including a flavor rod portion (for example, a tobacco rod portion) containing a flavor source, an inhalation port, and the like, so there has been a problem that it is difficult to accurately perform detection depending on arrangement of a capacitance sensor. Particularly, in a case of specifications that a prescribed end (hereinafter, also referred to as distal end) in a flavor stick is inserted into a non-combustion-type flavor inhaler, when an end (back end) opposite to the distal end is erroneously inserted into the non-combustion-type flavor inhaler, a smoke taste decreases because a flavor source is not heated and a flavor component does not sufficiently volatilize or a smoke taste decreases because a filter provided at the back end is heated and an unusual odor occurs. For this reason, it is desired to detect an erroneously inserted state. In this state, the segments are disposed at locations different from the prescribed ones, so there has been a problem that it is difficult to accurately detect information on the flavor stick.

An object of the present disclosure is contemplated in view of the above situation and is to provide a technology for accurately detecting that a flavor stick is inserted in a state different from a prescribed state.

Solution to Problem

(Aspect 1)

To achieve the above object, a non-combustion-type flavor inhaler according to one aspect of the present disclosure is
a non-combustion-type flavor inhaler including:

a container that accommodates a flavor stick having a first rod portion containing a flavor source and a second rod portion other than the first rod portion so that the flavor stick can be inserted and removed;
a first sensor that, when the flavor stick is accommodated in the container in a prescribed state where the first rod portion of the flavor stick is on a distal end side and the second rod portion is on a back end side with respect to the first rod portion, performs detection at least at a location where the first rod portion is disposed;
a second sensor that, when the flavor stick is accommodated in the container in the prescribed state, performs detection at least at a location where the second rod portion is disposed; and
a controller that determines whether the flavor stick is inserted in the prescribed state, based on at least one of a detection value of the first sensor and a detection value of the second sensor.

(Aspect 2)

In the above-described Aspect 1, a notification mechanism that notifies a user of a determination result by the controller may be included.

(Aspect 3)

In the above-described Aspect 1 or 2, the controller may

includes a memory that stores first range information indicating a range of a detection value that is obtained when the first rod portion is detected with the first sensor or the second sensor, and
when at least one of a condition that the detection value of the first sensor falls outside the range indicated by the first range information and a condition that the detection value of the second sensor falls within the range indicated by the first range information is satisfied, determines that the flavor stick is not inserted in the prescribed state.

(Aspect 4)

In the above-described Aspect 1 or 2, the controller may

include a memory that stores first range information indicating a range of a detection value that is obtained when the first rod portion is detected with the first sensor or the second sensor, and second range information indicating a range of a detection value that is obtained when the second rod portion is detected with the first sensor or the second sensor and indicating the range different from the range indicated by the first range information, and
when the detection value of the first sensor falls within the range indicated by the second range information and the detection value of the second sensor falls within the range indicated by the first range information, determines that the flavor stick is not inserted in the prescribed state.

(Aspect 5)

In any one of the above-described Aspects 1 to 4, the first sensor and the second sensor may be capacitance sensors.

(Aspect 6)

In the above-described Aspect 1 or 2, the first sensor and the second sensor may be capacitance sensors, and
when a second detection value detected with the second sensor is greater than a first detection value detected with the first sensor, it may be determined that the flavor stick is not inserted in the prescribed state.

(Aspect 7)

In the above-described Aspect 5 or 6, the first sensor may have a first electrode and a second electrode disposed at a distance from each other and detect a capacitance between the first electrode and the second electrode, and
the first electrode and the second electrode may be disposed across a space in which the first rod portion is accommodated such that, when the flavor stick is accommodated in the container, at least part of the first rod portion is inserted between the first electrode and the second electrode.

(Aspect 8)

In the above-described Aspect 7, the second sensor may have a third electrode and a fourth electrode disposed at a distance from each other and detect a capacitance between the third electrode and the fourth electrode, and
the third electrode and the fourth electrode may be disposed across a space in which the second rod portion is accommodated such that, when the flavor stick is accommodated in the container, at least part of the second rod portion (inhalation port) is inserted between the first electrode and the second electrode.

Means for solving the problem according to the present invention may adopt combinations as much as possible.

Advantageous Effects of Invention

According to the present invention, it is possible to provide a technology for accurately detecting insertion of a flavor stick in a state different from a prescribed state.

Brief Description of Drawings

[Fig. 1] Fig. 1 is a schematic configuration diagram of a non-combustion-type flavor inhaling system according to a first embodiment.
[Fig. 2] Fig. 2 is a perspective view of a tobacco stick according to the first embodiment.
[Fig. 3] Fig. 3 is a view that illustrates the internal structure of the tobacco stick according to the embodiment.
[Fig. 4] Fig. 4 is a view schematically showing the internal structure of a non-combustion-type flavor inhaler 30 according to the first embodiment.
[Fig. 5] Fig. 5 is a view showing an example in which planar electrodes are disposed.
[Fig. 6] Fig. 6 is a view showing an example in which curved electrodes are disposed.
[Fig. 7] Fig. 7 is a view showing an example of a first sensor and a second sensor formed on a flexible circuit board.
[Fig. 8] Fig. 8 is a view showing an example in which first to fourth electrodes are provided on an inner periphery of a circumferential wall.

[Fig. 9] Fig. 9 is a view showing an example in which the first to fourth electrodes are embedded in the circumferential wall.

[Fig. 10] Fig. 10 is a view showing the configuration of a controller

[Fig. 11] Fig. 11 is a graph showing the value of capacitance detected according to the location of a capacitance sensor in a prescribed state and in a reverse insertion state.

[Fig. 12] Fig. 12 is a view showing a positional relationship between the tobacco stick and the electrodes when measurement of Fig. 11 is performed.

[Fig. 13] Fig. 13 is a flowchart showing a control method that the controller executes.

[Fig. 14] Fig. 14 is a schematic configuration diagram of a non-combustion-type flavor inhaling system according to a second embodiment.

[Fig. 15] Fig. 15 is a view schematically showing the internal structure of a non-combustion-type flavor inhaler.

[Fig. 16] Fig. 16 is a schematic configuration diagram of a non-combustion-type flavor inhaler according to a third embodiment.

[Fig. 17] Fig. 17 is a side view of a flavor stick used in the third embodiment.

[Fig. 18] Fig. 18 is a schematic configuration diagram of a non-combustion-type flavor inhaler according to a fourth embodiment.

[Fig. 19] Fig. 19 is a view showing the configuration of a flavor stick used in the fourth embodiment.

Description of Embodiments

Embodiments of the flavor stick and the non-combustion-type flavor inhaling system according to the present invention will be described with reference to the drawings. Sizes, materials, shapes, relative positions, and the like of structural elements described in the present embodiments are one examples. For example, in the present embodiments, a flavor stick (hereinafter, also referred to as "tobacco stick") including a tobacco filler as a flavor source will be described as an example of the flavor stick. A flavor stick may contain another flavor component without containing a tobacco filler.

<First Embodiment>

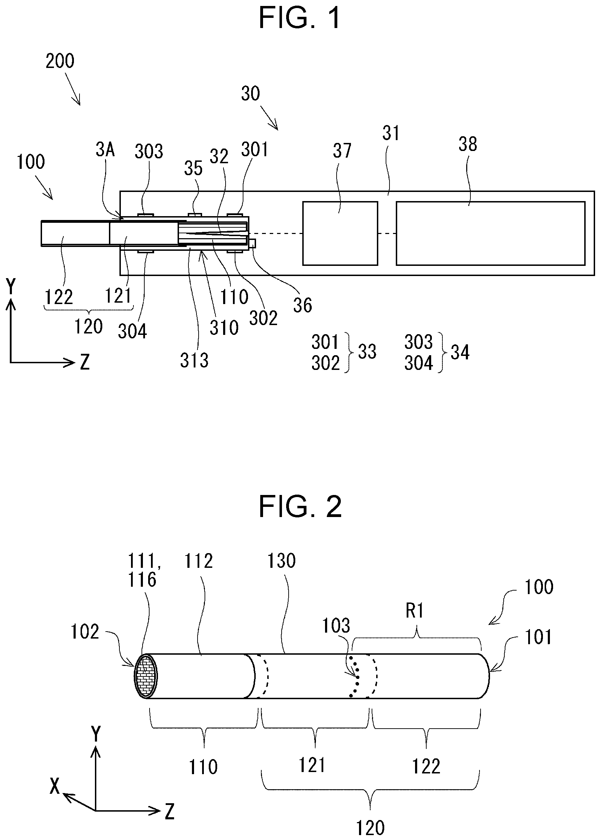

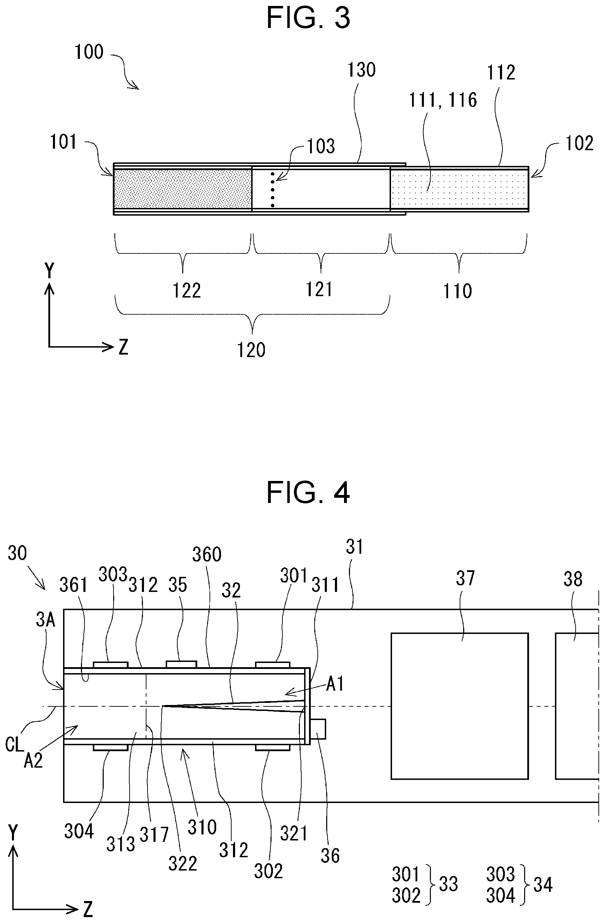

Fig. 1 is a schematic configuration diagram of a non-combustion-type flavor inhaling system 200 according to the embodiment. Fig. 2 is a perspective view of a tobacco stick 100 according to the embodiment. Fig. 3 is a view illustrating the internal structure of the tobacco stick 100 according to the embodiment. In Figs. 1 to 3, a right and left direction, an up and down direction, and a depth direction of the tobacco stick 100 or a non-combustion-type flavor inhaler 30 to which the tobacco stick 100 is inserted are respectively indicated as an X direction, a Y direction, and a Z direction. The same applies to the subsequent drawings. These directions are just illustrated for the sake of convenience of description and do not limit elements of the non-combustion-type flavor inhaling system 200. For example, the elements of the non-combustion-type flavor inhaling system 200 are not limited to arrangement of orientations shown in the drawings.

The non-combustion-type flavor inhaling system 200 includes the tobacco stick 100, and the non-combustion-type flavor inhaler 30 that heats a tobacco rod portion (flavor rod portion) 110 of the tobacco stick 100. The tobacco stick 100 is accommodated in a container cavity 313 of a container 310 through an insertion port 3A of the non-combustion-type flavor inhaler 30 so as to be freely inserted and removed.

When the non-combustion-type flavor inhaler 30 is used by a user, the tobacco stick 100 is inserted in the container cavity 313. In this state, when the non-combustion-type flavor inhaler 30 causes a heater 32 in the container 310 to generate heat to heat a tobacco filler in the tobacco stick 100, the non-combustion-type flavor inhaler 30 generates an aerosol containing a tobacco component to be made available for inhalation of the user.

[Tobacco Stick]

The tobacco stick 100 according to the present embodiment has a substantially cylindrical rod form. In the example shown in Figs. 2 and 3, the tobacco stick 100 includes the tobacco rod portion 110, a mouthpiece portion (inhalation port) 120, and tipping paper 130 uniting them as one. The mouthpiece portion 120 is coaxially coupled to the tobacco rod portion 110 when wrapped with the tipping paper 130 together with the tobacco rod portion 110.

Reference sign 101 indicates a mouthpiece end of the tobacco stick 100 (mouthpiece portion 120). Reference sign 102 indicates a distal end of the tobacco stick 100 on an opposite side to the mouthpiece end 101. The tobacco rod portion 110 is disposed adjacent to the distal end 102 side in the tobacco stick 100. In the example shown in Figs. 2 and 3, the tobacco stick 100 has a substantially constant diameter over the entire length in a longitudinal direction (hereinafter, also referred to as an axial direction or the Z direction) from the mouthpiece end (back end) 101 to the distal end 102.

[Tipping Paper]

The material of the tipping paper 130 is not limited. The material may be a paper made of general botanical fibers (pulp), a sheet using chemical fibers of polymers (polypropylene, polyethylene, nylon, or the like), a sheet of polymers, a metal foil, or the like, or a composite material combining some of them. For example, the tipping paper 130 may be made of a composite material obtained by laminating a polymer sheet to a paper substrate. Here, the tipping paper 130 means a sheet material connecting a plurality of segments in the tobacco stick 100, for example, coupling the tobacco rod portion 110 to the mouthpiece portion 120.

<Tobacco Rod Portion>

The tobacco rod portion 110 is one form of a flavor rod portion containing a tobacco filler 111 as a flavor source. The configuration of the tobacco rod portion 110 is not limited and may be a general mode. For example, the one in which a tobacco filler 111 is wrapped with wrapping paper 112 may be used.

[Tobacco Filler]

In the present embodiment, the tobacco filler 111 is configured to contain shredded tobacco. The material of shredded tobacco contained in the tobacco filler 111 is not limited and may be a known one, such as lamina and a leaf midrib. Alternatively, the material of shredded tobacco may be the one obtained by grinding dried tobacco leaves into ground tobacco with an average particle diameter greater than or equal to 20 $\mu$m and less than or equal to 200 $\mu$m, forming a sheet from the uniformed ground tobacco (hereinafter, also simply referred to as uniform sheet), and then shredding the uniform sheet. Alternatively, the material of shredded tobacco may be a so-called strand type in which the one obtained by shredding a uniform sheet, having a length equivalent to that of a tobacco rod in the longitudinal direction, substantially horizontally to the longitudinal direction of the tobacco rod is filled into the tobacco rod. The width of shredded tobacco is preferably greater than or equal to 0.5 mm and less than or equal to 2.0 mm for the purpose of being filled into the tobacco rod portion 110. The content of dried tobacco leaves contained in the tobacco rod portion 110 is not limited. The content of the dried tobacco leaves may be greater than or equal to 200 mg/rod portion and less than or equal to 800 mg/rod portion and preferably greater than or equal to 250 mg/rod portion and less than or equal to 600 mg/rod portion. This range is particularly suitable for the tobacco rod portion 110 with a circumference of 22 mm and a length of 20 mm.

As for tobacco leaves used to manufacture the shredded tobacco or the uniform sheet, various types of tobacco may be used. Examples of the types of tobacco include a flue cured type, a burley type, an orient type, a local type, other nicotiana-tabacum-series species, nicotiana-rustica-series species, and mixtures of them. The mixtures may be used by appropriately blending the above-described species to attain an intended taste. The details of the species of the tobaccos are disclosed in "Tobacco Dictionary, Tobacco Research Center, 2009.3.31". There is a plurality of existing methods for the method of manufacturing a uniform sheet, that is, a method of grinding tobacco leaves and working the ground tobacco leaves into a uniform sheet. The first one is a method of manufacturing a paper-made sheet by using a paper-making process. The second one is a method of casting a uniformed product onto a metal plate or a metal plate belt with a thin thickness after an appropriate solvent, such as water, is mixed with the ground tobacco leaves to be uniformed and drying the uniformed product to form a cast sheet. The third one is a method of manufacturing a calendared sheet by extruding a product obtained by mixing an appropriate solvent, such as water, with the ground tobacco leaves and uniformed, into a sheet. The type of the uniform sheet is disclosed in detail in "Tobacco Dictionary, Tobacco Research Center, 2009.3.31".

The moisture content of the tobacco filler 111 may be higher than or equal to 10wt% and lower than or equal to 15wt% with respect to the total amount of the tobacco filler 111 and preferably higher than or equal to 11wt% and lower than or equal to 13wt%. With such a moisture content, occurrence of wrapping stains is reduced, and machinability in manufacturing the tobacco rod portion 110 is improved. The size of shredded tobacco contained in the tobacco filler 111 and its preparation method are not limited. For example, the dried tobacco leaves may be the one shredded into a width greater than or equal to 0.5 mm and less than or equal to 2.0 mm. When a ground product of uniform sheet is used, dried tobacco leaves are ground into an average particle diameter of about 20 $\mu$m to about 200 $\mu$m, a sheet is formed from the uniformed ground product, and the one obtained by shredding the sheet into a width of greater than or equal to 0.5 mm and less than or equal to 2.0 mm may be used.

The tobacco filler 111 may contain an aerosol-source material that generates aerosol smoke. The type of the aerosol-source material is not limited. Extracted substances from various natural products and/or components of them may be selected according to an application. Examples of the aerosol-source material include glycerine, propylene glycol, triacetin, 1,3-butanediol, and mixtures of them. The content of the aerosol-source material in the tobacco filler 111 is not limited. From the viewpoint of sufficiently generating an aerosol and imparting a good flavor, the content of the aerosol-source material is commonly higher than or equal to 5wt% and preferably higher than or equal to 10wt% with respect to the total amount of the tobacco filler, and may be commonly lower than or equal to 50wt% and preferably higher than or equal to 15wt% and lower than or equal to 25wt%.

The tobacco filler 111 may contain a flavoring agent, such as menthol. The content of the flavoring agent in the tobacco filler 111 is not limited. From the viewpoint of imparting a good flavor, the content of the flavoring agent is commonly higher than or equal to 10000 ppm, preferably higher than or equal to 20000 ppm, and more preferably higher than or equal to 25000 ppm, and the content of the flavoring agent is commonly lower than or equal to 70000 ppm, preferably lower than or equal to 50000 ppm, more preferably lower than or equal to 40000 ppm, and further preferably lower than or equal to 33000 ppm. The tobacco filler 111 has a dielectric constant set so as to be greater than that of air or a filter (described later). Here, examples of the dielectric constant include air: one, cellulose/acetate: two to seven, glycerine: 47, propylene glycol: 32, and water: 80 (20°C). In this way, by adjusting the contents of an aerosol-source material containing glycerine or propylene glycol having a relatively large dielectric constant, shredded tobacco containing moisture, flavoring agent, and the like, the dielectric constant of the tobacco filler 111 is set so as to be greater than or equal to twice, preferably, greater than or equal to three times the dielectric constant of air or a filter (described later). Thus, detection with a capacitance sensor (described later) is favorably performed.

[Wrapping Paper]

The wrapping paper 112 is a sheet material for wrapping the tobacco filler 111. The configuration of the wrapping paper 112 is not limited, and a general sheet material may be used. For example, cellulose fiber paper may be used as base paper used for the wrapping paper 112. More specifically, hemp, wood, or a mixture of them may be used.

Other than the above, the wrapping paper 112 may contain a filler, such as calcium carbonate, titanium dioxide, and kaolin. The wrapping paper 112 may be added with various aids in addition to base paper and a filler and may be added with, for example, a water resistance improving agent, such as wet strength agent (WS agent) and sizing agent, for improvement in water resistance. The wrapping paper 112 may be coated as needed.

The axial length of the tobacco rod portion 110 can be changed as needed according to the size of a product. For example, the axial length of the tobacco rod portion 110 is greater than or equal to 5 mm, preferably greater than or equal to 10 mm, more preferably greater than or equal to 12 mm, and further preferably greater than or equal to 18 mm, and the axial length of the tobacco rod portion 110 is commonly less than or equal to 70 mm, preferably less than or equal to 50 mm, more preferably less than or equal to 30 mm, and further preferably less than or equal to 25 mm.

<Mouthpiece Portion>

The configuration of the tobacco stick 100 is not limited and may be a general mode. In the mode shown in Fig. 1, the mouthpiece portion 120 includes two segments, that is, a cooling segment 121 and a filter segment 122. The cooling segment 121 is disposed so as to be sandwiched between the tobacco rod portion 110 and the filter segment 122 in a state of being in contact with the tobacco rod portion 110 and the filter segment 122. In another mode, a clearance may be formed between the tobacco rod portion 110 and the cooling segment 121 and between the tobacco rod portion 110 and the filter segment 122. The mouthpiece portion 120 may be made up of a single segment. The mouthpiece portion 120 in the present embodiment is an example of the second rod portion.

[Cooling Segment]

The configuration of the cooling segment 121 is not limited as long as the cooling segment 121 has a function to cool tobacco mainstream smoke. Examples of the cooling segment 121 include the one formed by working thick paper into a cylindrical shape. In this case, the inside of the cylindrical shape is a cavity, and vapor containing an aerosol-source material and a tobacco flavor component contact with air in the cavity to be cooled.

One mode of the cooling segment 121 may be a paper core obtained by working single paper or laminated paper of multiple pieces of sheet into a cylindrical shape. To increase a cooling effect by bringing outside air at room temperature into contact with high-temperature vapor, a hole for introducing outside air is preferably provided around the paper core. Air holes 103 that are perforations for taking in air from an outside are provided in the cooling segment 121. The number of the air holes 103 in the cooling segment 121 is not limited.

[Filter Segment]

The configuration of the filter segment 122 is not limited as long as the filter segment 122 has the function of a general filter. Examples of the filter segment 122 include the one formed by working cellulose acetate tow into a cylindrical columnar shape. The filament denier and total denier of cellulose acetate tow are not limited. When the filter segment 122 has a circumference of 22 mm, preferably, the filament denier ranges from 5 g/9000m to 20 g/9000m, and the total denier ranges from 12000 g/9000m to 30000 g/9000m. The sectional shape of fiber of cellulose acetate tow may be a Y section or may be an R section. In the case where the filter segment 122 is formed by being filled with cellulose acetate tow, 5wt% or higher and 10wt% or lower of triacetin may be added to the weight of cellulose acetate tow to improve filter hardness. In the example shown in Fig. 2, the filter segment 122 is made up of a single segment. Alternatively, the filter segment 122 may be made up of a plurality of segments.

Examples of a general function of the filter in the filter segment 122 include adjusting the amount of air to be mixed when an aerosol and the like are inhaled, reducing a flavor, and reducing nicotine and tar; however, the filter does not need to have all of these functions. In an electrically heated tobacco product that tends to have a smaller amount of component generated and a lower packing fraction of tobacco filler as compared to a cigarette product, it is also one of important functions to reduce falling of tobacco filler while suppressing a filtering function.

The rod-like tobacco stick 100 preferably has a columnar shape that satisfies a shape of which an aspect ratio defined as follows is higher than or equal to one.

$$\text{Aspect ratio} = h/w$$

w denotes the width of the distal end 102 in the tobacco stick 100, h denotes the axial length, and it is preferable that $h \geq w$. The cross-sectional shape of the tobacco stick 100 is not limited and may be a polygonal shape, a rounded polygonal shape, a circular shape, an elliptical shape, or the like. The width w in the tobacco stick 100 is a diameter when the cross-sectional shape of the tobacco stick 100 is a circular shape, a longitudinal diameter when the cross-sectional shape of the tobacco stick 100 is an elliptical shape, or a diameter of a circumcircle or a longitudinal diameter of a circumellipse when the cross-sectional shape of the tobacco stick 100 is a polygonal shape or a rounded polygonal shape. The axial length h of the tobacco stick 100 is not limited. The axial length h of the tobacco stick 100 is, for example, commonly greater than or equal to 40 mm, preferably greater than or equal to 45 mm, and more preferably greater than or equal to 50 mm. The axial length h of the tobacco stick 100 is commonly less than or equal to 100 mm, preferably less than or equal to 90 mm, and more preferably less than or equal to 80 mm. The width w of the distal end 102 of the tobacco stick 100 is not limited and is, for example, commonly greater than or equal to 5 mm and preferably greater than or equal to 5.5 mm. The width w of the distal end 102 of the tobacco stick 100 is commonly less than or equal to 10 mm, preferably less than or equal to 9 mm, and more preferably less than or equal to 8 mm. The ratio between the length of the cooling segment 121 and the length of the filter segment 122 ((Cooling segment):(Filter segment)) in the length of the tobacco stick 100 is not limited. From the viewpoint of the delivery amount of a flavoring agent and an appropriate aerosol temperature, the ratio commonly ranges from 0.60:1.40 to 1.40:0.60, preferably ranges from 0.80:1.20 to 1.20:0.80, more preferably ranges from 0.85:1.15 to 1.15:0.85, further preferably ranges from 0.90:1.10 to 1.10:0.90, and particularly preferably ranges from 0.95:1.05 to 1.05:0.95. When the ratio between the length of the cooling segment 121 and the length of the filter segment 122 falls within the above range, a balance is kept among a cooling effect, the effect of suppressing losses resulting from adhesion of generated vapor and aerosol to the inner wall of the cooling segment 121, and a function of the filter to adjust the amounts of air and a flavor, so it is possible to realize a good flavor and the strength of a flavor.

<Non-Combustion-Type Flavor Inhaler>

Fig. 4 is a view schematically showing the internal structure of a non-combustion-type flavor inhaler 30 according to the first embodiment. The non-combustion-type flavor inhaler 30 has a housing 31 that is a casing for accommodating various components. A heater 32, a first sensor 33, a second sensor 34, a temperature sensor 35, an inhalation sensor 36, a controller 37, a power supply 38, and the like are accommodated in the housing 31.

[Container]

The housing 31 has a container 310 that extends from a front end toward a back end. The container 310 accommodates the tobacco stick 100 so that the tobacco stick 100 can be inserted and removed. The container 310 includes a cylindrical circumferential wall 312 and a disk-shaped back wall 311. The circumferential wall 312 extends in an insertion and removal direction of the tobacco stick 100 and defines the outer circumference of a space in which the tobacco stick 100 is inserted. The back wall 311 closes the back end of the circumferential wall 312 so as to define the back end of the space. The circumferential wall 312 and the back wall 311 of the container 310 may be formed integrally with the housing 31 or may be formed separately from the housing 31 and assembled to the housing 31.

An opening end of the circumferential wall 312 in the container 310 is open toward the outside of the housing 31 and serves as an insertion port 3A for inserting the tobacco stick 100. Then, an internal space of the circumferential wall 312 is a cylindrical columnar container cavity 313 that allows a distal end part of the tobacco stick 100 to be inserted and removed via the insertion port 3A. In Fig. 4, the reference sign CL indicates a central axis of the container cavity 313 in the insertion and removal direction of the tobacco stick 100. Hereinafter, a direction along the central axis CL is also referred to as axial direction. The outside diameter of the container cavity 313, that is, the inside diameter of the circumferential wall 312, may be equal to the outside diameter of the tobacco stick 100 or may be slightly greater than the outside diameter of the tobacco rod portion 110 or may be slightly less than the outside diameter of the tobacco rod portion 110.

The heater 32 is provided in the container cavity 313. The circumferential wall 312 and the back wall 311 of the container 310 is made of a material having a heat insulation capability and a heat resistance capability so as to withstand heat from the heater 32 and not to disperse heat from the heater 32. Examples of the material used for such the container 310 include a ceramic of alumina-silica, and resins, such as high-heat-resistant PEEK (polyetheretherketone), PPS (polyphenylene sulfide), and PTFE (polytetrafluoroethylene).

[Heater]

The heater 32 generates heat upon receiving electric power supplied from the controller 37 to heat the tobacco stick 100 accommodated in the container 310. In other words, the heater 32 is one mode of the heater that heats the tobacco stick 100.

The heater 32 is a substantially rod-shaped member extended along the axial direction of the container cavity 313 and has a cone shape in the present embodiment. The heater 32 protrudes forward from the center of the back wall 311 along the axial direction in the container 310. The reference sign 321 indicates a proximal end of the heater 32. The reference sign 322 indicates a distal end of the heater 32.

The heater 32 extends from the back wall 311 toward the insertion port 3A and gradually tapers from the proximal end 321 toward the distal end 322. The shape of the heater 32 is not limited. The shape of the heater 32 may be a rod shape with the same diameter from the proximal end 321 to the distal end 322 or a planar shape (blade shape).

The type of the heater 32 is not limited. For example, a configuration in which a heating wire (for example, a wire rod with a large electrical resistance, such as nichrome, iron-chromium, and iron-nickel) running around a steel material and disposed or a ceramic heater, a sheathed heater, or the like may be used. A sheathed heater is a heater in which a heating wire is covered with a metal pipe together with a filler.

When the tobacco stick 100 is inserted in the container cavity 313, the heater 32 is fitted into the tobacco rod portion 110 from the distal end 102 of the tobacco stick 100. Fig. 1 shows a state where the tobacco stick 100 is inserted in the container cavity 313. In this state, the heater 32 heats the tobacco rod portion 110 at a predetermined temperature upon receiving electric power supplied from the controller 37 (as will be described later). Here, in the container cavity 313, a space that is heated at a predetermined temperature with heat from the heater 32 is defined as heating region A1, and a space adjacent to the insertion port side of the heating region A1 in the axial direction (insertion and removal direction) is defined as non-heating region A2. The non-heating region A2 is formed on the insertion port side of the container cavity 313, and the heating region A1 is formed on the deeper side of the container cavity 313. Here, the heater 32 extends along the central axis CL in the heating region A1, and the heating region A1 is heated from inside. The heater 32 does not heat only a portion in contact and also heats a portion away from the heater 32 by radiation and heat transfer. For example, the heater 32 heats up to a location 317 on the insertion port side beyond the front end of the heater 32A in the axial direction at a predetermined temperature. For this reason, the heating region A1 is a region from the location 317 to the back wall 311 in the axial direction of the container 310. In other words, the location 317 is a boundary between the heating region A1 and the non-heating region A2. The non-heating region A2 ranges from the boundary 317 to the front end of the container cavity 313 in the axial direction. The boundary 317 may be determined as a boundary between a region that becomes a predetermined temperature and a region that becomes lower than the predetermined temperature when actually heated with the heater 32 or may be determined as an estimated boundary that is estimated between a region that becomes a predetermined temperature and a region that becomes lower than the predetermined temperature when the heater 32 is caused to generate heat under a preset condition. In the present embodiment, a boundary location between a region that becomes a predetermined temperature and a region that becomes lower than the predetermined temperature is estimated in the central axis CL, and a plane passing through the boundary location and orthogonal to the central axis CL is determined as the boundary 317 as indicated by the alternate long and two short dashes line in Fig. 4. When the tobacco stick 100 is inserted in the container cavity 313, the tobacco rod portion 110 is located in the heating region A1, and at least part of the mouthpiece portion (inhalation port) 120 is located in the non-heating region A2. When the tobacco stick 100 is set to a preset state, for example, the tobacco stick 100 is inserted in the container cavity 313 until the distal end 102 of the tobacco stick 100 contacts with the back wall 311 of the container 310, a part of the container cavity 313 where the tobacco rod portion 110 is located may be defined as the heating region A1, and a part where the mouthpiece portion 120 is located may be defined as the non-heating region A2.

[Sensor]

The first sensor (first sensor) 33 and the second sensor (second sensor) 34 are sensors that detect an inserted state of the tobacco stick 100. The first sensor 33 and the second sensor 34 in the present embodiment are capacitance sensors; however, the first sensor 33 and the second sensor 34 are not limited thereto.

The first sensor 33 detects the capacitance at a location where at least the tobacco rod portion 110 is disposed when the tobacco stick 100 is accommodated in the container 310. The first sensor 33 has a first electrode (first electrode) 301 and a second electrode (second electrode) 302 and detects a capacitance between these first electrode 301 and second electrode 302. The first electrode 301 and the second electrode 302 are disposed at opposite locations across the heating region A1 in a direction orthogonal to the axial direction of the container cavity 313 (radial direction). In other words, the first electrode 301 and the second electrode 302 are disposed such that, when the tobacco stick 100 is accommodated in the container cavity 313, at least part of the tobacco rod portion 110 is inserted between the first electrode 301 and the second electrode 302. At this time, a capacitance that is generated between the electrodes 301, 302 via the tobacco rod portion 110 changes depending on, for example, the presence or absence of insertion of the tobacco rod portion 110, an inserted location of the tobacco rod portion 110, the amount of moisture of a tobacco filler in the tobacco rod portion 110, an aerosol-source material, and the like. For this reason, the first sensor 33 can detect information indicating the state of the tobacco rod portion 110 by detecting the capacitance.

The second sensor 34 is a capacitance sensor that detects the capacitance at a location where at least the mouthpiece portion 120 is disposed at the time when the tobacco stick 100 is accommodated in the container 310. The second sensor 34 has a third electrode (third electrode) 303 and a fourth electrode (fourth electrode) 304 and detects a capacitance between these third electrode 303 and fourth electrode 304. The third electrode 303 and the fourth electrode 304 are disposed at opposite locations across the non-heating region A2 in a direction orthogonal to the axial direction of the container cavity 313 (radial direction). In other words, the third electrode 303 and the fourth electrode 304 are disposed such that, when the tobacco stick 100 is accommodated in the container cavity 313, at least part of the mouthpiece portion 120 is inserted between the third electrode 303 and the fourth electrode 304. At this time, a capacitance that is generated between the electrodes 303, 304 via the mouthpiece portion 120 changes depending on, for example, the presence or absence of insertion of the mouthpiece portion 120, an inserted location of the mouthpiece portion 120, moisture that adheres to the mouthpiece portion 120 as a result of puffing, the amount of deposit like an aerosol component, and the like. For this reason, the second sensor 34 can detect information indicating the state of the mouthpiece portion 120 by detecting the capacitance. Specific changes in capacitances detected by the first sensor 33 and the second sensor 34 will be described later.

The electrodes 301 to 304 are provided on the outer periphery 360 of the circumferential wall 312 of the container 310 at least along a container cavity depth direction (Z-axis direction). Here, the outer periphery 360 of the circumferential wall 312 is a surface opposite to a surface (inner periphery) 361 on the container cavity 313 side across the circumferential wall 312 in the radial direction of the circumferential wall 312 and is a surface located on an internal space side where the first sensor 33, the second sensor 34, the controller 37, and the like are accommodated in the housing 31.

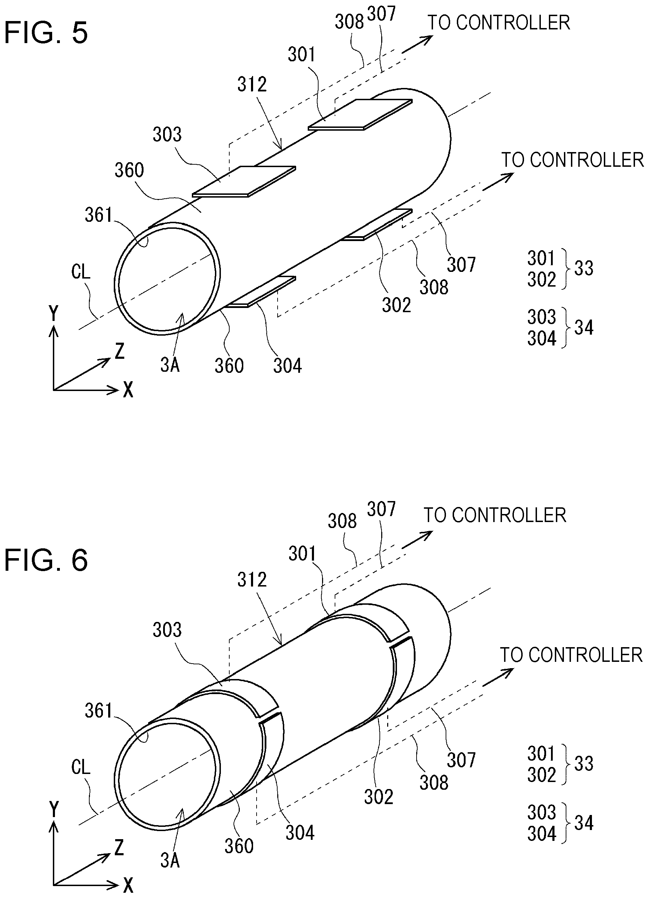

Fig. 5 is a view showing an example in which the planar electrodes 301 to 304 are disposed. As shown in Fig. 5, in the first sensor 33, the planar first electrode 301 and the planar second electrode 302 are provided at opposite locations on the outer periphery 360 across the circumferential wall 312 in the radial direction. The first electrode 301 and the second electrode 302 are held parallel to each other in a state of being in contact with the outer periphery 360. The first electrode 301 and the second electrode 302 are electrically connected to the controller 37 via a wiring line 307, and a detection result of capacitance is acquired by the controller.

Similarly, in the second sensor 34, the planar third electrode 303 and the planar fourth electrode 304 are provided at opposite locations on the outer periphery 360 across the circumferential wall 312 in the radial direction. The third electrode 303 and the fourth electrode 304 are held parallel to each other in a state of being in contact with the outer periphery 360. The third electrode 303 and the fourth electrode 304 are electrically connected to the controller 37 via a wiring line 308, and a detection result of capacitance is acquired by the controller.

The shape of each of the electrodes 301 to 304 is not limited and may be a shape other than a planar shape. Fig. 6 is a view showing an example in which the curved electrodes 301 to 304 are disposed. In the example of Fig. 6, each of the electrodes 301 to 304 is provided so as to be curved along the circumferential direction of the outer periphery 360 of the circumferential wall 312. The other configuration is the same as the example of Fig. 5. As shown in Fig. 6, with the curved electrodes 301 to 304, it is easier to reduce the size in the radial direction as compared to the example of Fig. 5. With the curved electrodes 301 to 304, each of the electrodes 301 to 304 is placed along the container cavity 313 in the circumferential direction and disposed at a location close to the tobacco stick 100 over the entire region in the circumferential direction, so the influence of noise is reduced, and the capacitance can be accurately detected.

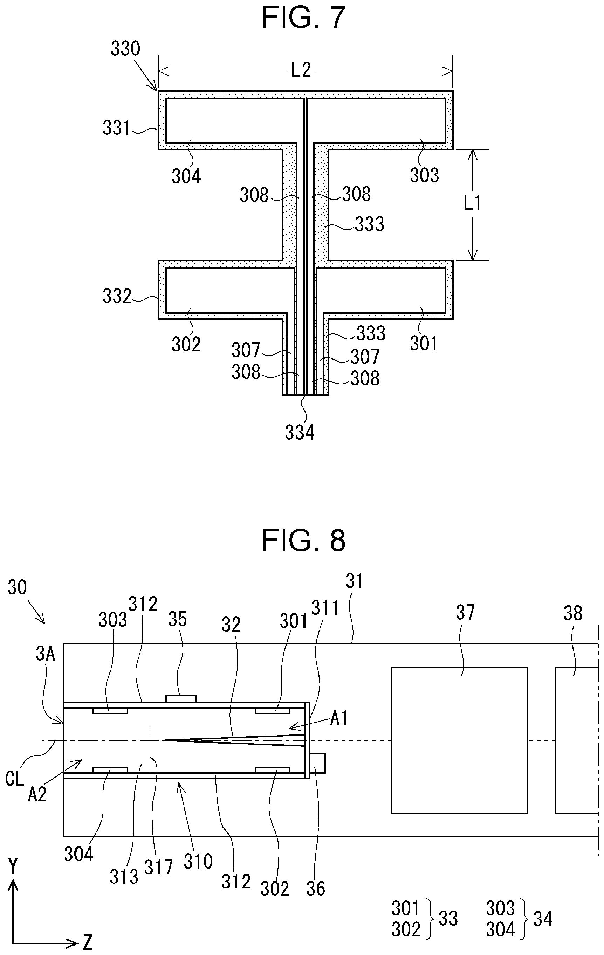

Fig. 7 is a view showing an example of the first sensor 33 and the second sensor 34 formed on a flexible circuit board. The flexible circuit board 330 includes a first strip portion 331 formed long in one direction, a third strip portion 333 formed long in a direction orthogonal to the first strip portion 331 from a central part of the first strip portion 331 in a longitudinal direction, and a second strip portion 332 disposed parallel to the first strip portion 331 at a distance L1 from the first strip portion 331 in the longitudinal direction of the third strip portion 333.

In the first strip portion 331, the third electrode 303 of the second sensor 34 is provided on one side and the fourth electrode 304 is disposed on the other side in the longitudinal direction at a predetermined distance provided at the center in the longitudinal direction. Similarly, in the second strip portion 332, the first electrode 301 of the first sensor 33 is provided on one side and the second electrode 302 is disposed on the other side in the longitudinal direction at a predetermined distance provided at the center in the longitudinal direction. In the third strip portion 333, the wiring lines 307, 308 respectively connected to the electrodes 301 to 304 are formed to an end 334 along the longitudinal direction of the third strip portion 333 so as to connect with the controller 37.

Each of the first strip portion 331 and the second strip portion 332 is formed such that a length L2 in the longitudinal direction is substantially the same or slightly shorter than a length in the circumferential direction of the outer periphery 360 of the circumferential wall 312. When the first strip portion 331 and the second strip portion 332 of the flexible circuit board 330 are disposed along the outer periphery 360 of the container 310, the electrodes 301 to 304 can be curved and provided as shown in Fig. 6. The distance L1 between the first strip portion 331 and the second strip portion 332 is determined such that, when the first sensor 33 is disposed on an outer peripheral side of the heating region A1, the second sensor 34 is disposed on an outer peripheral side of the non-heating region A2.

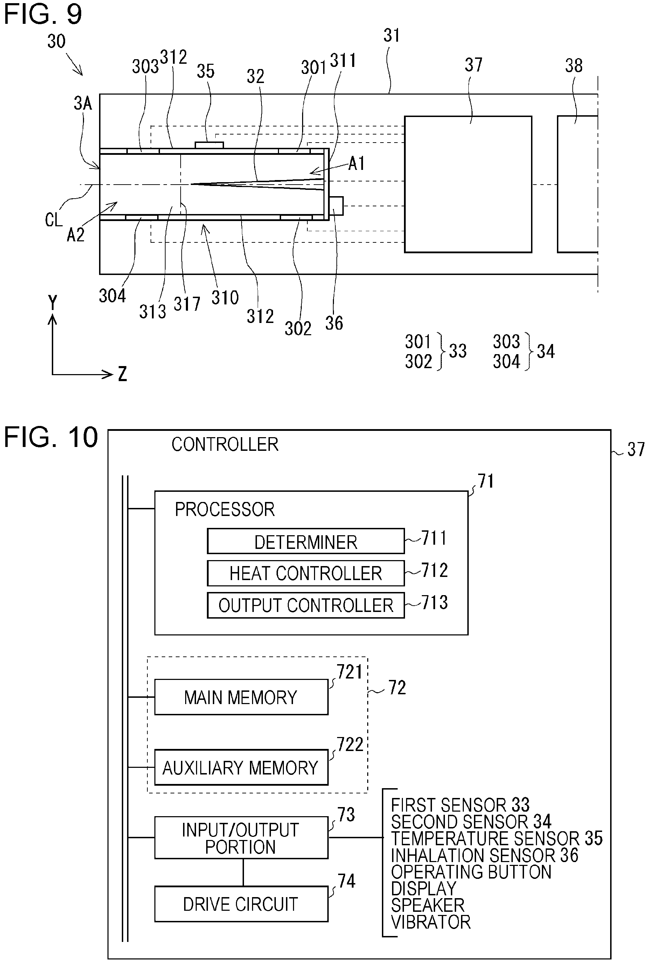

In the examples of Figs. 5 and 6, the electrodes 301 to 304 are provided on the outer periphery 360 of the circumferential wall 312; however, the configuration is not limited thereto. As shown in Fig. 8, the electrodes 301 to 304 may be provided on the inner periphery 361 of the circumferential wall 312. Furthermore, as shown in Fig. 9, the electrodes 301 to 304 may be embedded in the circumferential wall 312.

As shown in Fig. 1, the temperature sensor 35 is provided around an outer peripheral part of the heating region A1 in the container 310. The temperature sensor 35 is connected to the controller 37. The temperature sensor 35 detects the temperature of the heating region A1 and inputs a detection result to the controller 37. Furthermore, the inhalation sensor 36 is provided at the container 310. The inhalation sensor 36 is a sensor for detecting the status of puff, such as whether puff is performed, and is, for example, a pressure sensor that detects a pressure in the container cavity 313. The inhalation sensor 36 is connected to the controller 37 and inputs a detection result to the controller 37. When the controller 37 does not use information on the temperature for control, the temperature sensor 35 may be omitted. Similarly, when information on inhalation is not used for control, the inhalation sensor 36 may be omitted.

[Controller]

Fig. 10 is a view showing the configuration of the controller 37. The controller 37 controls the operating state of the non-combustion-type flavor inhaler 30, such as control for heating with the heater 32. The controller 37 is a computer that includes, for example, a processor 71, such as a CPU (Central Processing Unit), a DSP (Digital Signal Processor), and an FPGA (Field-Programmable Gate Array), a memory 72, such as a RAM (Random Access Memory) and a ROM (Read Only Memory), and an input/output portion 73. The controller 37 according to the present embodiment includes a drive circuit 74 of the heater 32.

The memory 72 may include the one that functions as a main memory 721 and the one that functions as an auxiliary memory 722. The memory 72 may be integrated with the processor 71 (one chip). Examples of the memory 72 include a volatile memory, such as a RAM, a nonvolatile memory, such as a ROM, an EPROM (Erasable Programmable ROM), an SSD, a storage medium, such as a removable medium.

An operating system (OS), various programs (firmware), various data tables, various databases, setting data, user data, and the like for executing the operation of the non-combustion-type flavor inhaler 30 can be stored in the memory 72.

The input/output portion 73 is a means that inputs information, such as turning on or off of power by a user (smoker), to the processor 71 or outputs information to the user. The input/output portion 73 is, for example, an interface that operates the first sensor 33, the second sensor 34, the temperature sensor 35, and the inhalation sensor 36 at predetermined timing and acquires detection values from the sensors 33 to 36. The input/output portion 73 according to the present embodiment may include an operating button, an input means, such as a touch panel, and an output means (notification mechanism), such as a display, a vibrator, and a speaker. The input/output portion 73 may include a communicator for communicating with an external apparatus via a communication line. For example, the communicator can update firmfare, a heating profile, and the like by connecting with another computer via a communication cable, receiving a program and data for controlling the non-combustion-type flavor inhaler 30, and storing the program and data in the memory 72. The display is a means that displays information and may be, for example, an indicator, such as an LED, a liquid crystal display device, or an organic EL display device.

The drive circuit 74 causes the heater 32 to operate by supplying electric power from the power supply 38 to the heater 32 in accordance with an instruction from the processor 71. The drive circuit 74 is, for example, a converter that adjusts the amount of current to be passed through the heater 32.

The controller 37 functions as predetermined functional units, for example, a determiner 711, a heat controller 712, and an output controller 713, when the processor 71 reads a program stored in the memory 72 to a working area of the main memory and runs the program. These functional units are not limited to those implemented based on a program (software). Part or all of them may be made up of a hardware circuit, such as a processor, an integrated circuit, and a logic circuit.

The determiner 711 determines operation by a user, the state of the tobacco stick 100, and a heating situation by the heater 32 based on detection results of the sensors 33 to 36 and input information from the input means. For example, the determiner 711 determines whether the tobacco stick 100 is inserted in a prescribed state, based on at least one of the first detection value of the first sensor 33 and the second detection value of the second sensor 34. A determination condition as to whether the tobacco stick 100 is inserted in the prescribed state will be described later. The determiner 711 may determine the presence or absence of the tobacco stick 100, an inserted location of the tobacco stick 100, whether the tobacco stick 100 is already heated, the amount of moisture of the tobacco stick 100, the amount of aerosol source of the tobacco stick 100, the amount of flavor source of the tobacco stick 100, the type of flavor stick, and the like.

The heat controller 712 controls electric power supplied from the power supply 38 to the heater 32 via the drive circuit 74 by controlling the drive circuit 74 based on a determination result of the determiner 711. For example, the heat controller 712 executes control to start heating when it is determined that the tobacco stick 100 is inserted in the container cavity 313 and set the heater 32 to a predetermined temperature.

The output controller 713 outputs a notification, a warning, or the like to the user based on a determination result of the determiner 711. For example, when the tobacco stick 100 is inserted reversely to the prescribed state, the output controller 713 notifies the user by outputting a voice message "Tobacco Stick Is Inserted in Reverse Orientation" or the like from a speaker. Other than the above, the output controller 713 may display on a display, output a warning sound, output a vibration with a vibrator, or the like, as an output to the user.

[Detection of Tobacco Stick with Capacitance Sensor]

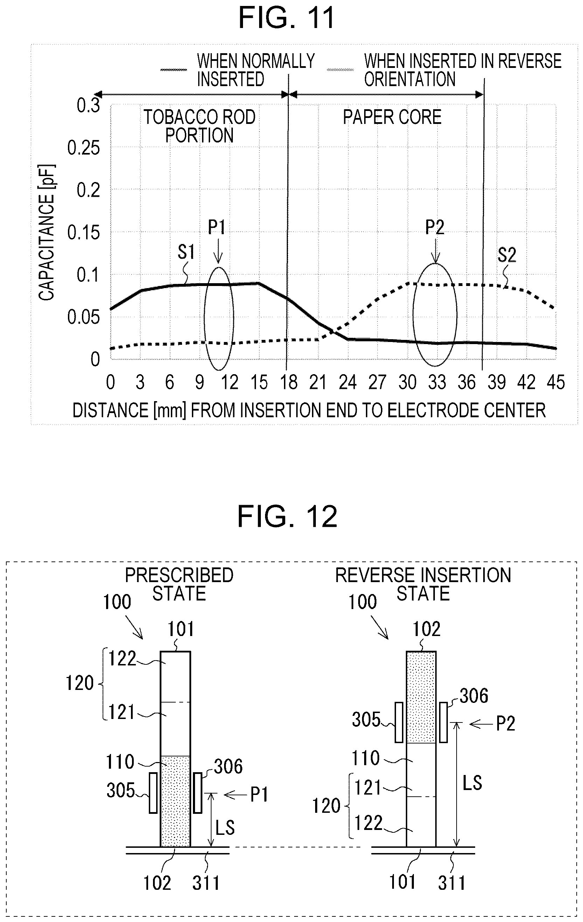

Fig. 11 is a graph showing the value of capacitance detected according to the location of a capacitance sensor in a prescribed state and in a reverse insertion state. Fig. 12 is a view showing a positional relationship between the tobacco stick 100 and the electrodes 305, 306 when measurement of Fig. 11 is performed.

As shown in Fig. 12, the tobacco stick 100 accommodated in the container 310 is inserted until the insertion-side end contacts with the back wall 311 of the container 310. In the present embodiment, a state where the tobacco stick 100 is inserted in the container 310 while the tobacco rod portion 110 is on the distal end side and the mouthpiece portion 120 not the tobacco rod portion 110 is on the back end side is defined as the prescribed state. In this case, the tobacco stick 100 is inserted until the distal end 102 of the tobacco stick 100 contacts with the back wall 311. Because the tobacco stick 100 has a rod shape with a substantially uniform diameter from the distal end to the back end, the tobacco stick 100 can be inserted into the container 310 even in a state of orientation reverse to the prescribed state, that is, a state where the mouthpiece portion 120 not the tobacco rod portion 110 is on the distal end side. This state is also referred to as a reverse insertion state. In this case, the tobacco stick 100 is inserted until the mouthpiece end (back end) 101 of the tobacco stick 100 contacts with the back wall 311. The electrode 305 and the electrode 306 sandwich the tobacco stick 100 in the radial direction, and measurement is performed while a distance LS from each of the insertion-side ends 101, 102 of the tobacco stick 100 to the electrode center is changed along the insertion and removal direction of the tobacco stick 100.

In Fig. 11, the ordinate axis represents the value of capacitance detected with the capacitance sensor, and the abscissa axis represents the location of the capacitance sensor. The location of the capacitance sensor in Fig. 11 is indicated by the distance LS from the end of the tobacco stick 100 inserted in the container 310 to the center of each of the electrodes 305, 306 of the capacitance sensor. The continuous line S1 represents the result obtained by measuring a capacitance while changing the location of the electrodes 305, 306 for the tobacco stick 100 inserted in the prescribed state, and the dashed line S2 represents the result measured similarly in the reverse insertion state.

When the tobacco stick 100 is inserted in the prescribed state, a high capacitance is detected at a part close to an insertion end (distal end) of the tobacco stick 100 and a low capacitance is detected at a part far from the insertion end, as indicated by the continuous line S1. On the other hand, when the tobacco stick 100 is inserted in the reverse insertion state, a low capacitance is detected at a part close to the insertion end (mouthpiece end) of the tobacco stick 100 and a high capacitance is detected at a part far from the insertion end, as indicated by the dashed line S2. In other words, the capacitance is high at a part where the tobacco rod portion 110 is present, and a low capacitance is detected at a part where the mouthpiece portion 120 is present. This is presumably because the dielectric constant of the tobacco rod portion 110 is higher than that of the mouthpiece portion 120 and, when, for example, the tobacco rod portion 110 is present between the electrodes 305, 306, the degree of polarization due to electrostatic induction is high and, as a result, the capacitance increases.

For this reason, in the present embodiment, sensors are disposed at a plurality of locations in the insertion and removal direction of the tobacco stick 100, and a different detection result is obtained between when the tobacco stick 100 is inserted in the prescribed state and the tobacco stick 100 is inserted in the reverse insertion state. For example, the first sensor 33 is disposed at the location P1 where the tobacco rod portion 110 is disposed and the second sensor 34 is disposed at the location P2 where the mouthpiece portion 120 is disposed when the tobacco stick 100 is accommodated in the container 310 in the prescribed state.

The first sensor 33 disposed in this way detects the capacitance in a range H1 from a predetermined value V1 to a predetermined value V2 when the tobacco stick 100 is inserted in the prescribed state and detects the capacitance in a range H2 from a predetermined value V3 to a predetermined value V4 when the tobacco stick 100 is inserted in the reverse insertion state, as shown in Fig. 11.

The second sensor 34 detects the capacitance in the range H2 from the predetermined value V3 to the predetermined value V4 when the tobacco stick 100 is inserted in the prescribed state and detects the capacitance in the range H1 from the predetermined value V1 to the predetermined value V2 when the tobacco stick 100 is inserted in the reverse insertion state, as shown in Fig. 11.

The range H2 is a range different from the range H1 and does not overlap the range H1 in the example of Fig. 11 and is a range lower than the range H1. In the present embodiment, the first sensor 33 and the second sensor 34 have substantially the same configuration and have the same measurement target, the same measurement value is obtained. In other words, the first sensor 33 and the second sensor 34 both detect the capacitance in the range H1 for the tobacco rod portion 110 and detects the capacitance in the range H2 for the mouthpiece portion 120. Not limited thereto, the first sensor 33 and the second sensor 34 may have different sizes and installation modes of the electrodes and may be configured to obtain different values for the same measurement target. In other words, the range in which the tobacco rod portion 110 is detected and the range in which the mouthpiece portion 120 is detected may be set so as to be different between the first sensor 33 and the second sensor 34. The controller 37 stores information (first range information) indicating the range H1 and information (second range information) indicating the range H2 in the memory 72 to determine the inserted state of the tobacco stick 100.

[Control Method]

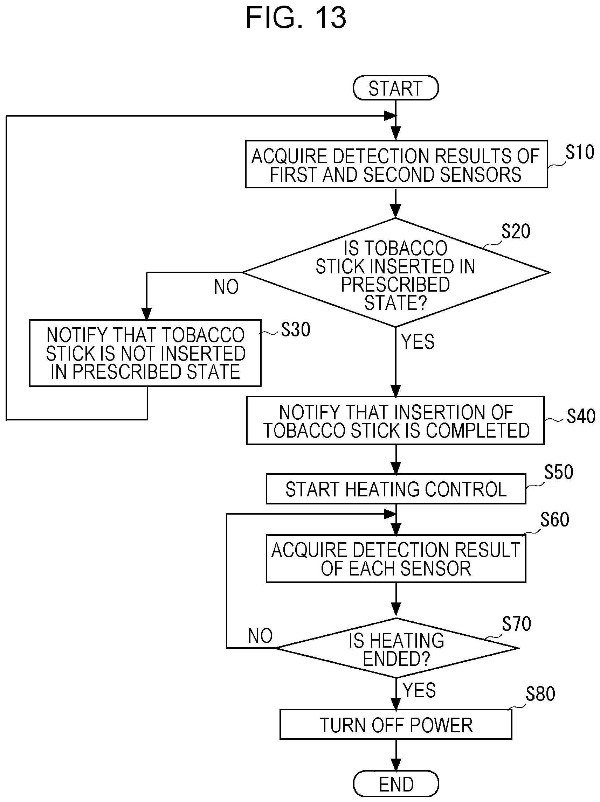

Fig. 13 is a flowchart showing a control method that the controller 37 executes. The controller 37 starts the process of Fig. 13 when the power of the non-combustion-type flavor inhaler 30 is turned on.
In step S10, the controller 37 acquires detection values of the first sensor 33 and the second sensor 34. The controller 37 stores the acquired detection values in the memory 72.
In step S20, the controller 37 determines whether the tobacco stick 100 is inserted in the prescribed state, based on the detection values detected in step S10. When, for example, the second detection value detected with the second sensor 34 is less than the first detection value detected with the first sensor 33, it is determined that the tobacco stick 100 is inserted in the prescribed state (affirmative determination). On the other hand, when the second detection value detected with the second sensor 34 is greater than the first detection value detected with the first sensor 33, it is determined that the tobacco stick 100 is not inserted in the prescribed state, that is, the tobacco stick 100 is inserted in the reverse insertion state (negative determination).
The determination condition is not limited thereto. For example, the controller 37 may determine that the tobacco stick 100 is not inserted in the prescribed state when at least one of a condition that the detection value of the first sensor 33 falls outside the range indicated by the first range information and a condition that the detection value of the second sensor 34 falls within the range indicated by the first range information is satisfied. In this case, the controller 37 determines that the tobacco stick 100 is inserted in the prescribed state when at least one of the condition that the detection value of the first sensor 33 falls within the range indicated by the first range information and the condition that the detection value of the second sensor 34 falls outside the range indicated by the first range information.
The controller 37 may determine that the tobacco stick 100 is not inserted in the prescribed state when the detection value of the first sensor 33 falls within the range indicated by the second range information and the detection value of the second sensor 34 falls within the range indicated by the first range information. In this case, the controller 37 may determine that the tobacco stick 100 is inserted in the prescribed state when the detection value of the first sensor 33 falls within the range indicated by the first range information and the detection value of the second sensor 34 falls within the range indicated by the second range information.
When the determination is negative in step S20, the controller 37 proceeds to step S30 and notifies the user by activating the notification mechanism. For example, the controller 37 notifies the user by providing notification through voice output of a message "Tobacco Stick Is Inserted in Reverse Orientation. Check Insertion Orientation and Insert Again." from a speaker, displaying the message on a display, outputting a warning sound from the speaker, blinking a warning indicator (warning lamp), vibrating a vibrator in a specific pattern, or the like. Other than the above, the output controller 713 notifies the user by displaying on a display, outputting a warning sound, outputting a vibration with a vibrator, or the like, as an output to the user.
After the notification in step S30, the controller 37 returns to step S10. When notification is provided again after the notification in step S30, notification may be provided after a predetermined time. When the determination is not affirmative in step S20 even when a predetermined number of times of notification is provided, the process of Fig. 13 may be ended.
On the other hand, when the determination is affirmative in step S20, the controller 37 proceeds to step S40 and notifies the user that the tobacco stick 100 is inserted in the prescribed state by, for example, blinking an indicator. In the example of Fig. 13, notification is provided in each of the case where the tobacco stick 100 is inserted in the prescribed state and the case where the tobacco stick 100 is inserted in the reverse insertion state. Alternatively, notification of the reverse insertion state may be provided by not performing display or output of sound when the tobacco stick 100 is inserted in the reverse insertion state, and performing output, such as blinking the indicator, only when the tobacco stick 100 is inserted in the prescribed state. In other words, when the tobacco stick 100 is inserted reversely, notification that the tobacco stick 100 is not inserted in the prescribed state may be provided by outputting nothing.
In step S50, the controller 37 controls heating based on a predetermined heating profile. The controller 37 controls electric power supplied to the heater 32 such that, for example, the temperature of a region to be heated with the heater 32 (heating region) becomes a heating temperature determined in the heating profile.

In step S60, the controller 37 obtains detection values of the first and second sensors 33, 34, the temperature sensor 35, and the inhalation sensor 36.

In step S70, the controller 37 determines whether to end heating, based on the detection results acquired in step S60. In other words, for example, when the amount of moisture of the tobacco rod portion is less than a predetermined value, when the number of puffs has reached a predetermined value, or the like, the controller 37 makes affirmative determination based on the detection results acquired in step S60.

When the determination is affirmative in step S70, the controller 37 proceeds to step S80, turns off the power of the non-combustion-type flavor inhaler 30, and ends the process of Fig. 13.

[Advantageous Effects of Embodiment]

According to the present embodiment, since at least the capacitance at the tobacco rod portion 110 and the capacitance at the mouthpiece portion 120 are detected with the first sensor 33 and the second sensor 34, and the state of the tobacco stick 100 is detected based on these detection values, so information on the tobacco stick 100 can be accurately acquired. For this reason, the non-combustion-type flavor inhaler 30 according to the present embodiment can provide a technology for accurately detecting insertion of the tobacco stick 100 in a state different from the prescribed state.

With the non-combustion-type flavor inhaler 30 according to the present embodiment, when it is determined that the tobacco stick 100 is not inserted in the prescribed state, it is possible to make a user be aware of an error of an inserted state by notifying the user, so usability is improved.

<Second Embodiment>

In the above-described first embodiment, an example in which the electrodes of the first sensor 33 are disposed along the circumferential wall of the container 310 has been described. A second embodiment differs from the above-described first embodiment in a configuration in which the electrodes of a first sensor 33A are disposed at the bottom of the container 310. The other configuration is the same, so like reference signs denote the same elements, and the description will not be repeated.

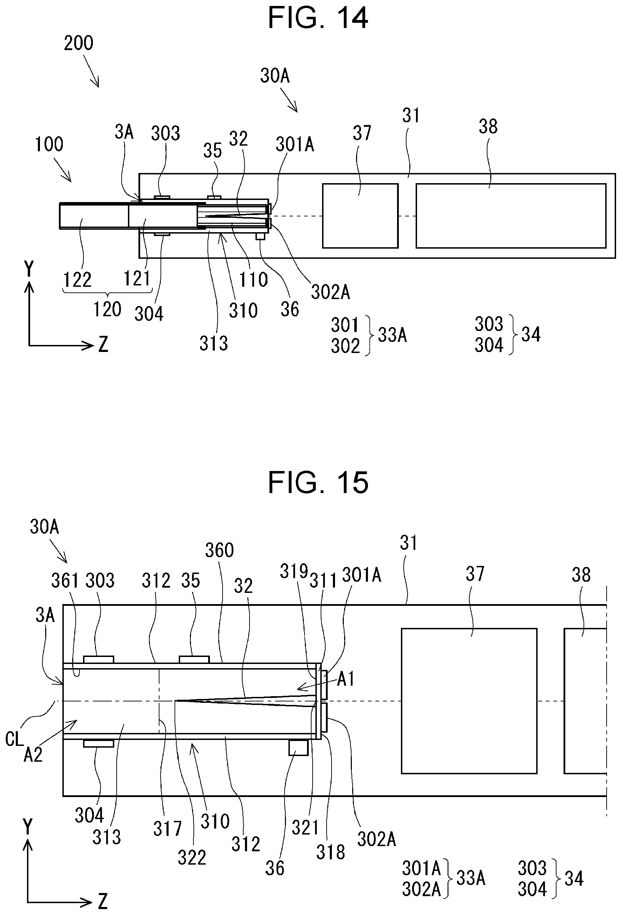

Fig. 14 is a schematic configuration diagram of a non-combustion-type flavor inhaling system according to the second embodiment. Fig. 15 is a view schematically showing the internal structure of a non-combustion-type flavor inhaler 30A.

The first sensor 33A is a capacitance sensor that detects the capacitance at the distal end of the tobacco stick 100 when the tobacco stick 100 is accommodated in the container 310. The tobacco rod portion 110 may be disposed at the distal end of the tobacco stick 100 or may be not at the distal end of the tobacco rod. For example, a filter segment may be provided at the distal end. In other words, in the present embodiment, a first rod portion includes a segment (for example, a filter segment) other than the tobacco rod portion 110. When the filter segment is provided at the distal end, the first sensor 33A detects the capacitance of the filter segment.

The first sensor 33A has a first electrode 301A and a second electrode 302A and detects a capacitance between these first electrode 301A and second electrode 302A. The first electrode 301A and the second electrode 302A are disposed along a bottom 319 of the container 310 with which the distal end 102 of the tobacco stick 100 contacts, when the tobacco stick 100 is inserted in the container 310 in the prescribed state. In other words, the first electrode 301A and the second electrode 302A are disposed on the same plane parallel to the bottom 319 of the container 310 such that a detection face faces the container cavity 313 side. At this time, a capacitance that is generated between the electrodes 301A, 302A via the tobacco rod portion 110 changes depending on, for example, the presence or absence of insertion of the tobacco rod portion 110, an inserted location of the tobacco rod portion 110, the amount of moisture of a tobacco filler in the tobacco rod portion 110, an aerosol-source material, and the like. For this reason, the first sensor 33A can detect information indicating the state of the tobacco rod portion 110 by detecting the capacitance. The first electrode 301A and the second electrode 302A are electrically connected to the controller 37 via a wiring line 307, and a detection result of capacitance is acquired by the controller 37.

As shown in Fig. 15, in the first sensor 33A, the planar first electrode 301A and the planar second electrode 302A are provided on a surface on an opposite side of the bottom 319 of the back wall 311 in the container 310, that is, a surface 318 on the inner side of the casing in which the controller 37 and the like are accommodated. The first electrode 301A and the second electrode 302A are disposed on the same plane 318 such that a minimum distance LA between the first electrode 301A and the second electrode 302A is less than or equal to 7 mm and preferably less than or equal to 4 mm. The first electrode 301A and the second electrode 302A may be disposed in proximity to each other across an electrically insulating film or the like to avoid electrical conduction.

Each of the electrodes 301A, 302A just needs to have a shape formed along a distal end surface 104 of the tobacco stick 100. For example, the outer shape is not limited and may be a rectangular shape, a polygonal shape other than the rectangular shape, an elliptical shape, or the like. For example, each of the electrodes 301A, 302A may be formed in a semispherical shape, and, when both the electrodes 301A, 302A are disposed side by side on the same plane 318, the outer shape of both the electrodes 301A, 302A may be formed so as to form substantially the same circular shape as the distal end surface of the tobacco stick 100.

Each of the electrodes 301A, 302A is provided on the surface 318 on the opposite side of the bottom 319 of the back wall 311 in the container 310 and is proximate to the distal end surface 104 of the tobacco stick 100 via the back wall 311 in a state accommodated in the casing. For this reason, the electrodes 301A, 302A are disposed at a location close to the tobacco stick 100 without interfering with elements disposed around the container 310, so it is possible to accurately detect the capacitance, and the electrodes 301A, 302A are protected from impact or dirt as a result of insertion or removal of the tobacco stick 100.

A configuration that determines an inserted state of the tobacco stick 100 based on the detection results of the first sensor 33A and the second sensor 34 is the same as that of the above-described first embodiment. When the first sensor 33A is provided at the bottom 319 of the container 310, the configuration differs from the second sensor 34, so the first range information and the second range information that respectively indicate ranges H1, A2 of capacitance to be detected by the sensors 33A, 34 may be respectively set.

According to the present embodiment, a capacitance at the distal end 102 of the tobacco stick 100 and a capacitance at the mouthpiece portion 120 of the tobacco stick 100 are detected with the first sensor 33A and the second sensor 34, and the state of the tobacco stick 100 is detected based on these detection values. For this reason, the non-combustion-type flavor inhaler 30A according to the present embodiment can provide a technology for accurately detecting insertion of the tobacco stick 100 in a state different from the prescribed state.

<Third Embodiment>

In the above-described first embodiment, an example in which the first sensor 33 and the second sensor 34 are capacitance sensors has been described. A third embodiment differs from the above-described first embodiment in a configuration in which a first sensor 33B and a second sensor 34B are photoelectric sensors. The other configuration is the same, so like reference signs denote the same elements, and the description will not be repeated.

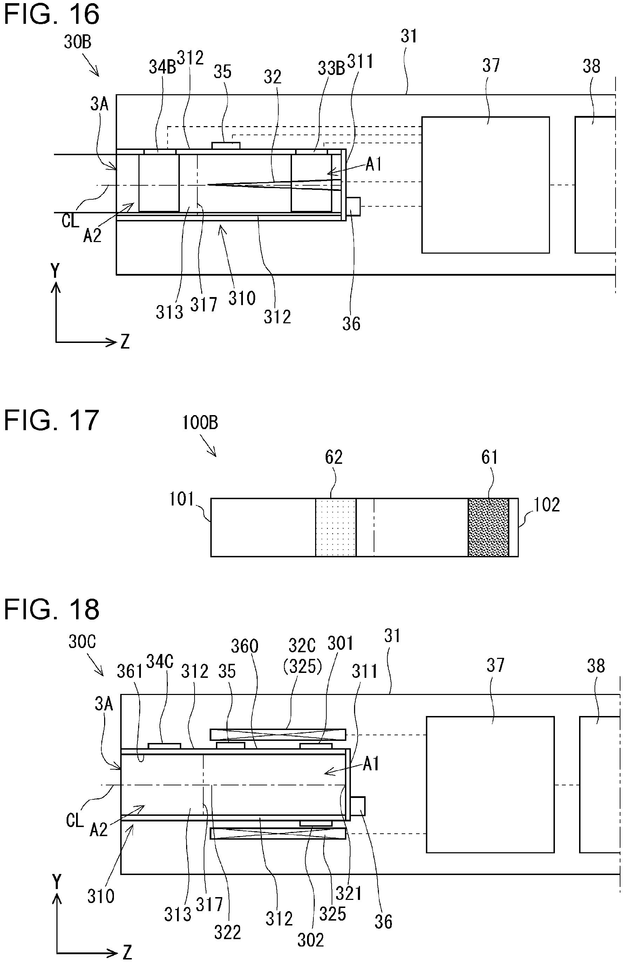

Fig. 16 is a schematic configuration diagram of a non-combustion-type flavor inhaler 30B according to the third embodiment. Fig. 17 is a side view of a flavor stick used in the third embodiment.

As shown in Fig. 17, a tobacco stick (flavor stick) 100B used in the present embodiment has markers 61, 62 along the outer periphery. The first marker 61 is provided on a distal end side where a first rod portion (tobacco rod portion 110) is disposed in the tobacco stick 100B, and the second marker 62 is provided on a back end side where a second rod portion (mouthpiece portion 120) is disposed. The markers 61, 62 according to the present embodiment are provided on the outer circumference of the wrapping paper 112 by printing.

The first sensor 33B is provided at a location where the first marker 61 is disposed when the tobacco stick 100B is inserted in the container 310 in the prescribed state and where the second marker 62 is disposed when the tobacco stick 100B is inserted in the reverse insertion state.

The second sensor 34B is provided at a location where the second marker 62 is disposed when the tobacco stick 100B is inserted in the container 310 in the prescribed state and where the first marker 61 is disposed when the tobacco stick 100B is inserted in the reverse insertion state.

The first sensor 33B and the second sensor 34B each apply detection light to the outer periphery of the tobacco stick 100B and measure light reflected from the marker 61 or the marker 62, and convert the reflected light into an electrical signal indicating the value of color, density (reflectance), and the like of the marker 61 or the marker 62 to obtain a detection result.

Each of the markers 61, 62 is formed in a selected density by, for example, changing the shape and density of dots. Not limited to this, each of the markers 61, 62 may be identified by color, a difference from a predetermined color (color difference), bar code, or the like. The color and density of the wrapping paper 112 itself may be detected as the second marker 62. In this case, addition of the marker 62 may be omitted.

First range information that indicates the range of a detection value obtained when the first marker 61 is detected with the first sensor 33B and the second sensor 34B and second range information that indicates the range of a detection value obtained when the second marker 62 is detected with the first sensor 33B and the second sensor 34B is obtained by an experiment or the like in advance and stored in the memory 72. A configuration that determines an inserted state of the tobacco stick 100B based on the detection results of the first sensor 33B and the second sensor 34B, the first range information, and the second range information is the same as that of the above-described first embodiment.

According to the present embodiment, even when sensors with a system other than capacitance sensors are used as the first sensor 33B and the second sensor 34B, it is possible to detect the markers 61, 62 and detect the state of the tobacco stick 100 based on these detection values. For this reason, the non-combustion-type flavor inhaler 30B according to the present embodiment can provide a technology for accurately detecting insertion of the tobacco stick 100B in a state different from the prescribed state.

<Fourth Embodiments

A fourth embodiment differs from the above-described first embodiment in a configuration including an electromagnetic induction heating-type heater, a configuration that heats a susceptor in a tobacco stick 100C, and a sensor that detects a susceptor. The other configuration is the same, so like reference signs denote the same elements, and the description will not be repeated.

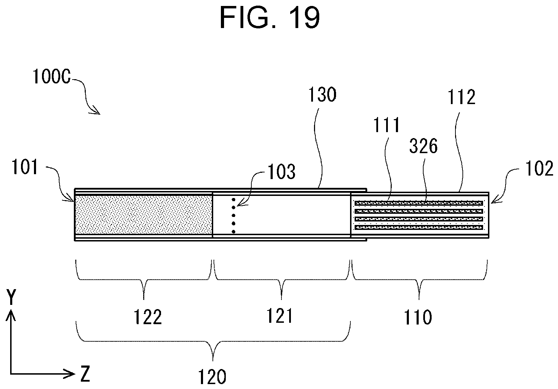

Fig. 18 is a schematic configuration diagram of a non-combustion-type flavor inhaler 30C according to the fourth embodiment. Fig. 19 is a view showing the configuration of a flavor stick used in the fourth embodiment. A heater 32C according to the present embodiment includes an electromagnetic induction heating coil (induction coil) 325. The tobacco stick 100C includes a heat generator (susceptor) 326 in the tobacco rod portion 110. The heat generator 326 generates heat by electromagnetic induction of the coil 325. The heat generator 326 is a substantially plate-shaped member formed long along the axial direction of the tobacco rod portion 110. The shape of the heat generator 326 is not limited. The heat generator 326 generates heat by electromagnetic induction to heat the surrounding tobacco filler 111.

The power supply (battery unit) 38 is a power supply that supplies electric power for heating to the coil 325 via the controller 37 and supplies DC current to the controller 37 in the present embodiment. In the present embodiment, the drive circuit 74 (Fig. 10) of the controller 37 includes a DC/AC inverter for supplying high-frequency AC current to the coil 325. When an operating switch is operated or when the controller 37 determines that the tobacco stick 100 is inserted in the container cavity 313, the controller 37 supplies AC current with a predetermined frequency to the coil 325 on the assumption that an instruction to start heating operation is issued.

The coil 325 supplied with AC current generates a varying electromagnetic field (alternating field) with the predetermined frequency. The frequency of the electromagnetic field is, for example, higher than or equal to 1 kHz and lower than or equal to 30 MHz, preferably higher than or equal to 50 kHz and lower than or equal to 500 kHz, and more preferably higher than or equal to 100 kHz and lower than or equal to 250 kHz. In the present embodiment, it is assumed that the inductance L of the coil is 1 μH and the frequency of the varying electromagnetic field is 200 kHz.

The varying electromagnetic field generates eddy current in the heat generator 326 disposed in the hollow part of the coil 325, that is, in the varying electromagnetic field, and causes the heat generator 326 to generate heat with this eddy current loss.

The coil 325 also functions as a first sensor that detects the heat generator 326. For example, when the tobacco stick 100 is inserted and the heat generator 326 that is a metal is located in the coil 325, a local field in the coil 325 changes, so a change in the local field is detected.

When the tobacco stick 100 is accommodated in the container 310, the second sensor 34C is provided at a location where the mouthpiece portion 120 is disposed. The second sensor 34C is a metal sensor that detects the heat generator 326 that is a metal.

First range information that indicates the range of a detection value obtained when the heat generator 326 is detected with the first sensor (coil 325) and the second sensor 34C and second range information that indicates the range of a detection value obtained when the mouthpiece portion 120 is detected with the first sensor (coil 325) and the second sensor 34C is obtained by an experiment or the like in advance and stored in the memory 72. A configuration that determines an inserted state of the tobacco stick 100C based on the detection results of the first sensor (coil 325) and the second sensor 34C, the first range information, and the second range information is the same as that of the above-described first embodiment.

According to the present embodiment, it is possible to detect the heat generator 326 with the first sensor (coil 325) and the second sensor 34C and detect the state of the tobacco stick 100 based on these detection values. For this reason, the non-combustion-type flavor inhaler 30C according to the present embodiment can provide a technology for accurately detecting insertion of the tobacco stick 100C in a state different from the prescribed state.

<Other Embodiments>

The components in the above-described embodiments are illustrative and not restrictive, and addition, omission, replacement, combination, and other alteration of components are possible as needed within the scope not departing from the scope of the present disclosure. The present disclosure may be the following modes.

(Aspect 1)

A non-combustion-type flavor inhaler includes:

a container that accommodates a flavor stick having a first rod portion containing a flavor source and a second rod portion other than the first rod portion so that the flavor stick can be inserted and removed; a first sensor that, when the flavor stick is accommodated in the container in a prescribed state where the first rod portion of the flavor stick is on a distal end side and the second rod portion is on a back end side with respect to the first rod portion, performs detection at least at a location where the first rod portion is disposed; a second sensor that, when the flavor stick is accommodated in the container in the prescribed state, performs detection at least at a location where the second rod portion is disposed; and a controller that determines whether the flavor stick is inserted in the prescribed state, based on at least one of a detection value of the first sensor and a detection value of the second sensor.

(Aspect 2)

The non-combustion-type flavor inhaler according to Aspect 1 further includes a notification mechanism that notifies a user of a determination result made by the controller.

(Aspect 3)

In the non-combustion-type flavor inhaler according to Aspect 1 or 2, the controller

includes a memory that stores first range information indicating a range of a detection value that is obtained when the first rod portion is detected with the first sensor or the second sensor, and
when at least one of a condition that a detection value of the first sensor falls outside the range indicated by the first range information and a condition that a detection value of the second sensor falls within the range indicated by the first range information is satisfied, determines that the flavor stick is not inserted in the prescribed state.

(Aspect 4)

In the non-combustion-type flavor inhaler according to Aspect 1 or 2, the controller

includes a memory that stores first range information indicating a range of a detection value that is obtained when the first rod portion is detected with the first sensor or the second sensor, and second range information indicating a range of a detection value that is obtained when the second rod portion is detected with the first sensor or the second sensor and indicating the range different from the range indicated by the first range information, and
when a detection value of the first sensor falls within the range indicated by the second range information and a detection value of the second sensor falls within the range indicated by the first range information, determines that the flavor stick is not inserted in the prescribed state.

(Aspect 5)

In the non-combustion-type flavor inhaler according to any one of Aspects 1 to 4, the first sensor and the second sensor are capacitance sensors.

(Aspect 6)

In the non-combustion-type flavor inhaler according to Aspect 1 or 2, the first sensor and the second sensor are capacitance sensors, and
when a second detection value detected with the second sensor is greater than a first detection value detected with the first sensor, it is determined that the flavor stick is not inserted in the prescribed state.

(Aspect 7)

In the non-combustion-type flavor inhaler according to Aspect 5 or 6, the first sensor has a first electrode and a second electrode disposed at a distance from each other and detects a capacitance between the first electrode and the second electrode, and
the first electrode and the second electrode are disposed across a space in which the first rod portion is accommodated such that, when the flavor stick is accommodated in the container, at least part of the first rod portion is inserted between the first electrode and the second electrode.

(Aspect 8)

In the non-combustion-type flavor inhaler according to Aspect 7, the second sensor has a third electrode and a fourth electrode disposed at a distance from each other and detects a capacitance between the third electrode and the fourth electrode, and
the third electrode and the fourth electrode are disposed across a space in which the inhalation port is accommodated such that, when the flavor stick is accommodated in the container, at least part of the inhalation port is inserted between the first electrode and the second electrode.

Reference Signs List

100 tobacco stick
101 mouthpiece end
102 distal end
103 air hole
110 tobacco rod portion
111 filler
112 wrapping paper
120 mouthpiece portion
121 cooling segment
122 filter segment
130 tipping paper
200 non-combustion-type flavor inhaling system
30, 30A, 30B, 30C non-combustion-type flavor inhaler
301 first electrode
302 second electrode
303 third electrode
304 fourth electrode
305, 306 electrode
307, 308 wiring line
31 housing
310 container
311 back wall

312 circumferential wall
313 container cavity
32, 32A heater
321 proximal end
322 distal end
325 gap
325 coil
326 heat generator
32C heater
33 first sensor
330 flexible circuit board
334 end
34 second sensor
35 temperature sensor
36 inhalation sensor
37 controller
38 power supply (battery unit)
3A insertion port
71 processor
711 determiner
712 heat controller
713 output controller
72 memory
73 input/output portion
74 drive circuit

**Claims**

1.  A non-combustion-type flavor inhaler comprising:

    a container that accommodates a flavor stick having a first rod portion containing a flavor source and a second rod portion other than the first rod portion so that the flavor stick can be inserted and removed;
    a first sensor that, when the flavor stick is accommodated in the container in a prescribed state where the first rod portion of the flavor stick is on a distal end side and the second rod portion is on a back end side with respect to the first rod portion, performs detection at least at a location where the first rod portion is disposed;
    a second sensor that, when the flavor stick is accommodated in the container in the prescribed state, performs detection at least at a location where the second rod portion is disposed; and
    a controller that determines whether the flavor stick is inserted in the prescribed state, based on at least one of a detection value of the first sensor and a detection value of the second sensor.

2.  The non-combustion-type flavor inhaler according to claim 1, further comprising a notification mechanism that notifies a user of a determination result made by the controller.

3.  The non-combustion-type flavor inhaler according to claim 1 or 2, wherein the controller

    includes a memory that stores first range information indicating a range of a detection value that is obtained when the first rod portion is detected with the first sensor or the second sensor, and
    when at least one of a condition that the detection value of the first sensor falls outside the range indicated by the first range information and a condition that the detection value of the second sensor falls within the range indicated by the first range information is satisfied, determines that the flavor stick is not inserted in the prescribed state.

4.  The non-combustion-type flavor inhaler according to claim 1 or 2, wherein the controller

    includes a memory that stores first range information indicating a range of a detection value that is obtained when the first rod portion is detected with the first sensor or the second sensor, and second range information indicating a range of a detection value that is obtained when the second rod portion is detected with the first sensor or the second sensor and indicating the range different from the range indicated by the first range information, and
    when the detection value of the first sensor falls within the range indicated by the second range information and the detection value of the second sensor falls within the range indicated by the first range information, determines that the flavor stick is not inserted in the prescribed state.

5.  The non-combustion-type flavor inhaler according to any one of claims 1 to 4, wherein the first sensor and the second sensor are capacitance sensors.

6.  The non-combustion-type flavor inhaler according to claim 1 or 2, wherein

    the first sensor and the second sensor are capacitance sensors, and
    when a second detection value detected with the second sensor is greater than a first detection value detected with the first sensor, it is determined that the flavor stick is not inserted in the prescribed state.

7.  The non-combustion-type flavor inhaler according to claim 5 or 6, wherein

    the first sensor has a first electrode and a second electrode disposed at a distance from each other and detects a capacitance between the first electrode and the second electrode, and
the first electrode and the second electrode are disposed across a space in which the first rod portion is accommodated such that, when the flavor stick is accommodated in the container, at least part of the first rod portion is inserted between the first electrode and the second electrode.

8. The non-combustion-type flavor inhaler according to claim 7, wherein

the second sensor has a third electrode and a fourth electrode disposed at a distance from each other and detects a capacitance between the third electrode and the fourth electrode, and
the third electrode and the fourth electrode are disposed across a space in which the second rod portion is accommodated such that, when the flavor stick is accommodated in the container, at least part of the second rod portion is inserted between the first electrode and the second electrode.

## FIG. 1

## FIG. 2

# FIG. 3

# FIG. 4

FIG. 5

FIG. 6

## FIG. 7

## FIG. 8

## FIG. 9

## FIG. 10

# FIG. 11

# FIG. 12

# FIG. 13

START

ACQUIRE DETECTION RESULTS OF FIRST AND SECOND SENSORS — S10

IS TOBACCO STICK INSERTED IN PRESCRIBED STATE? — S20

NO

NOTIFY THAT TOBACCO STICK IS NOT INSERTED IN PRESCRIBED STATE — S30

YES

NOTIFY THAT INSERTION OF TOBACCO STICK IS COMPLETED — S40

START HEATING CONTROL — S50

ACQUIRE DETECTION RESULT OF EACH SENSOR — S60

IS HEATING ENDED? — S70

NO

YES

TURN OFF POWER — S80

END

# FIG. 14

# FIG. 15

## FIG. 16

## FIG. 17

## FIG. 18

FIG. 19

## INTERNATIONAL SEARCH REPORT

International application No.

**PCT/JP2022/042134**

### A. CLASSIFICATION OF SUBJECT MATTER

*A24F 40/20*(2020.01)i; *A24F 40/40*(2020.01)i; *A24F 40/50*(2020.01)i; *A24F 40/53*(2020.01)i
FI: A24F40/50; A24F40/53; A24F40/40; A24F40/20

According to International Patent Classification (IPC) or to both national classification and IPC

### B. FIELDS SEARCHED

Minimum documentation searched (classification system followed by classification symbols)

A24F40/20; A24F40/40; A24F40/50; A24F40/53

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2021-523683 A (NICOVENTURES TRADING LTD) 09 September 2021 (2021-09-09) paragraphs [0015]-[0062], fig. 1-10 | 1-8 |
| Y | JP 2018-532400 A (PHILIP MORRIS PRODUCTS SA) 08 November 2018 (2018-11-08) paragraphs [0069]-[0072], fig. 1-2 | 1-8 |
| Y | JP 2017-510270 A (BRITISH AMERICAN TOBACCO (INVESTMENTS) LIMITED) 13 April 2017 (2017-04-13) paragraphs [0039]-[0047], fig. 2-3 | 7-8 |
| A | WO 2021/123321 A1 (JT INTERNATIONAL S.A.) 24 June 2021 (2021-06-24) specification, p. 8, line 31 to p. 10, line 28, fig. 1-3 | 1-8 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 December 2022** | **20 December 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/042134**

| Patent document cited in search report | | | Publication date (day/month/year) | Patent family member(s) | | | Publication date (day/month/year) |
|---|---|---|---|---|---|---|---|
| JP | 2021-523683 | A | 09 September 2021 | US | 2021/0093011 | A1 | |
| | | | | paragraphs [0025]-[0072], fig. 1-10 | | | |
| | | | | BR | 112020020020 | A2 | |
| | | | | CA | 3095121 | A1 | |
| | | | | EP | 3773033 | A1 | |
| | | | | KR | 10-2020-0122392 | A | |
| | | | | RU | 2766175 | C1 | |
| | | | | WO | 2019/185749 | A1 | |
| JP | 2018-532400 | A | 08 November 2018 | US | 2019/0261683 | A1 | |
| | | | | paragraphs [0077]-[0080], fig. 1-2 | | | |
| | | | | CA | 2999210 | A1 | |
| | | | | CN | 108024580 | A | |
| | | | | EP | 3352594 | A1 | |
| | | | | IL | 257571 | A | |
| | | | | KR | 10-2018-0058709 | A | |
| | | | | MX | 2018003277 | A | |
| | | | | RU | 2018114885 | A3 | |
| | | | | WO | 2017/051011 | A1 | |
| JP | 2017-510270 | A | 13 April 2017 | US | 2018/0049469 | A1 | |
| | | | | paragraphs [0059]-[0067], fig. 2-3 | | | |
| | | | | AU | 2015233388 | A1 | |
| | | | | CA | 2940693 | A1 | |
| | | | | CN | 106455707 | A | |
| | | | | EP | 3119224 | A1 | |
| | | | | KR | 10-2016-0124853 | A | |
| | | | | KR | 10-2019-0014596 | A | |
| | | | | RU | 2016137560 | A | |
| | | | | UA | 123621 | C2 | |
| | | | | US | 2020/0260790 | A1 | |
| | | | | WO | 2015/140312 | A1 | |
| WO | 2021/123321 | A1 | 24 June 2021 | (Family: none) | | | |

Form PCT/ISA/210 (patent family annex) (January 2015)

**EP 4 458 174 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017510270 W
- JP 2019185748 A
- JP 2021523683 W

**Non-patent literature cited in the description**

- Tobacco Dictionary. Tobacco Research Center, 31 March 2009